# EUROPEAN PATENT APPLICATION

(11) **EP 3 355 371 A1**
(43) Date of publication of application: **01.08.2018**
(21) Application number: 15895860.3
(22) Date of filing: 15.10.2015
(51) Int. Cl.: H01L 33/64, F21S 2/00

(54) **LIQUID-FILLED LED LAMP**

(30) Priority: 24.09.2015 CN 201510618505
(71) Applicant: Li, Feng, Shenzhen, Guangdong 518000 (CN)
(72) Inventor: Li, Feng, Shenzhen, Guangdong 518000 (CN)
(74) Representative: Lang, Christian
(86) International application number: PCT/CN2015/091992
(87) International publication number: WO 2017/049680

(57) **Abstract**

An LED lamp packaged by liquid sealant contains: a transparent sheet (10), a grid casing (20), a printed circuit board (PCB) (30), and a lid (40). The transparent sheet (10) covers on a top of the grid casing (20), the PCB (30) is defined between the grid casing (20) and the lid (40), and the lid (40) covering a bottom of the grid casing (20) and fixing the PCB (30). The grid casing (20) includes at least one feeding orifice formed on the top thereof and communicating with an accommodation chamber (24) defined on the bottom of the grid casing (20), and liquid sealant is fed into the grid casing (20) from the at least one feeding orifice, and after feeding the liquid sealant into the grid casing (20), the least one feeding orifice is closed.

## Description

### FIELD OF THE INVENTION

The present invention relates to an LED lamp, and more particularly to the LED lamp which is packaged by liquid sealant.

### BACKGROUND OF THE INVENTION

A conventional LED lamp cannot dissipate heat from lights of multiple LED chips, so the multiple LED chips are broken easily after a period of using time.

So how to package the LED lamp and dissipate heat from the LED lamp are inevitable.

The present invention has arisen to mitigate and/or obviate the afore-described disadvantages.

### SUMMARY OF THE INVENTION

The primary objective of the present invention is to provide an LED lamp packaged by liquid sealant which dissipates heat quickly by using the liquid sealant and is simplified.

To obtain above-mentioned objective, an LED lamp packaged by liquid sealant provided by the present invention contains: a transparent sheet, a grid casing, a printed circuit board (PCB), and a lid.

The transparent sheet covers on a top of the grid casing, the PCB is defined between the grid casing and the lid, and the lid covers a bottom of the grid casing and fixes the PCB.

The grid casing includes at least one feeding orifice formed on the top thereof and communicating with an accommodation chamber defined on the bottom of the grid casing, and liquid sealant is fed into the grid casing from the at least one feeding orifice, and after feeding the liquid sealant into the grid casing, the least one feeding orifice is closed.

Preferably, the grid casing includes a surrounding portion and a grille portion surrounded by the surrounding portion, wherein the grille portion has multiple refraction rooms, and each of the multiple refraction room is in an inverted cone shape.

Preferably, the grid casing further includes a fixing shoulder surrounding the top of the grille portion, wherein a size of the fixing shoulder is equal to the transparent sheet so that the fixing shoulder fixes the transparent sheet.

Preferably, the PCB is accommodated under the grille portion and includes multiple LED chips fixed thereon, wherein each of the multiple LED chips corresponds to said each refraction room of the grille portion.

Preferably, the PCB is a ceramic PCB or an aluminum PCB.

Preferably, the grid casing further includes the accommodation chamber defined on the bottom thereof, and the lid retains in the accommodation chamber of the grid casing so as to fix the PCB.

Preferably, the accommodation chamber is rectangular and communicating with the surrounding portion of the grid casing, such that the lid retains in the accommodation chamber of the grid casing.

Preferably, the transparent sheet includes a fluorescent film facing to the grid casing.

Preferably, the liquid sealant has heat conductivity, low volatility, and high burning point.

Preferably, the liquid sealant is any one of heat conduction oil, silicone oil, ultrapure water, distilled water, and deionized water.

Thereby, the LED lamp of the present invention is packaged by the liquid sealant, and the multiple LED chips are fixed on the PCB, such that after the liquid sealant is fed into the grid casing, the heat of the multiple LED chips is dissipated through the liquid sealant quickly.

Preferably, said each LED chip emits the lights in said each refraction room of the grille portion so as to enhance luminous efficiency by using said each refraction room. Furthermore, said each refraction room of the grille portion accommodates the liquid sealant so that when the liquid sealant is fed into the grille portion of the grid casing, the liquid sealant contacts with said each LED chip and the fluorescent film, hence the lights quickly transmits to exterior environment via the liquid sealant and the fluorescent film.

### BRIEF DESCRIPTION OF THE DRAWINGS

FIG. 1 is a perspective view showing the exploded components of an LED lamp packaged by liquid sealant according to a preferred embodiment of the present invention.

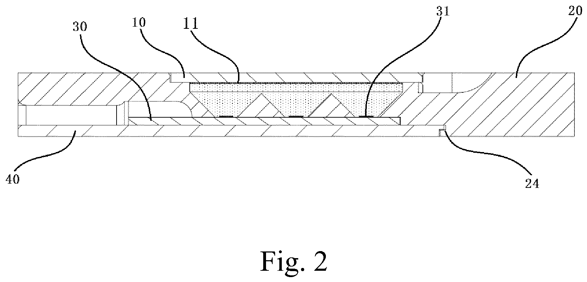

FIG. 2 is a cross sectional view showing the assembly of the LED lamp packaged by the liquid sealant according to the preferred embodiment of the present invention.

### DETAILED DESCRIPTION OF THE PREFERRED EMBODIMENTS

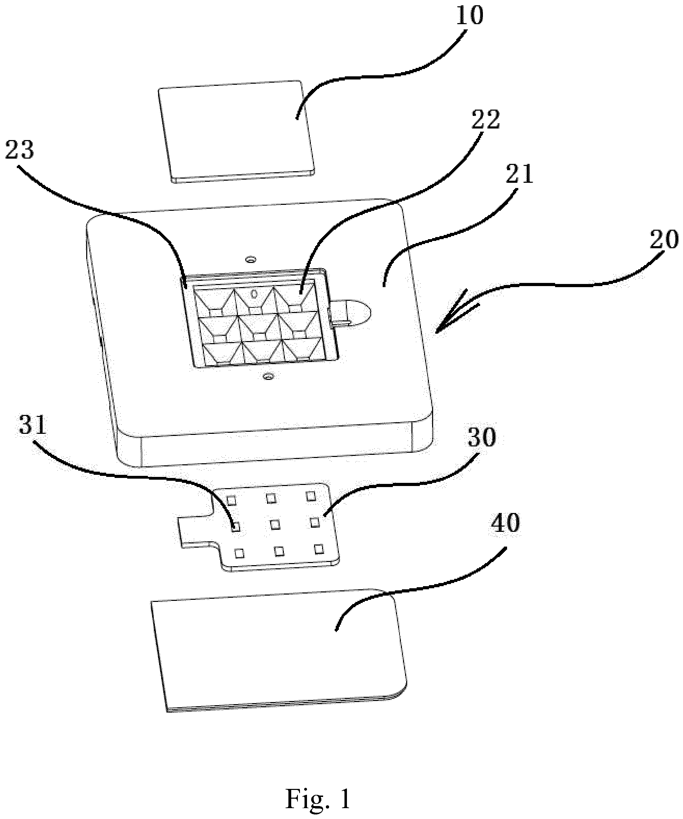

With reference to FIG. 1, an LED lamp packaged by liquid sealant according to a preferred embodiment of the present invention comprises: a transparent sheet 10, a grid casing 20, a printed circuit board (PCB) 30, and a lid 40. The transparent sheet 10 covers on a top of the grid casing 20, the PCB 30 is defined between the grid casing 20 and the lid 40, and the lid 40 covers a bottom of the grid casing 20 and fixes the PCB 30.

The grid casing 20 includes at least one feeding orifice formed on the top thereof and communicating with an accommodation chamber 24, hence liquid sealant is fed into the grid casing 20 from the at least one feeding orifice, and the least one feeding orifice is closed, after feeding the liquid sealant into the grid casing 20.

The grid casing 20 includes a surrounding portion 21 and a grille portion 22 surrounded by the surrounding portion 21, wherein the grille portion 22 has multiple refraction rooms, and each of the multiple refraction room is in an inverted cone shape.

A top of the grille portion 22 is covered by the transparent sheet 10, and a bottom of the grille portion 22 is covered by the lid 40, thus closing the grille portion 22.

Said each refraction room of the grille portion 22 has a hollow area and four peripheral walls surrounding the hollow area in which each of multiple LED chips 31 are housed.

The PCB 30 is accommodated under the grille portion 22 and includes the multiple LED chips 31 fixed thereon, wherein said each LED chip 31 corresponds to said each refraction room of the grille portion 22.

The grid casing 20 further includes a fixing shoulder 23 surrounding the top of the grille portion 22, wherein a size of the fixing shoulder 23 is equal to the transparent sheet 10 so that the fixing shoulder 23 fixes the transparent sheet 10.

The PCB 30 is a ceramic PCB or an aluminum PCB.

The grid casing 20 further includes the accommodation chamber 24 defined on the bottom thereof, and the lid 40 retains in the accommodation chamber 24 of the grid casing 20 so as to fix the PCB 30.

The accommodation chamber 24 is rectangular and communicating with the surrounding portion 21 of the grid casing 20, such that the lid 40 retains in the accommodation chamber 24 of the grid casing 20.

The transparent sheet 10 includes a fluorescent film 11 facing to the grid casing 20, and the fluorescent film 11 is made of any one of sapphire, acrylic, and glass.

Said each LED chip 31 emits lights in said each refraction room of the grille portion 22 so as to enhance luminous efficiency by way of said each refraction room. Preferably, said each refraction room of the grille portion 22 accommodates the liquid sealant so that when the liquid sealant is fed into the grille portion 22 of the grid casing 20, the liquid sealant contacts with said each LED chip 31 and the fluorescent film 11, hence the lights transmits to exterior environment via the liquid sealant and the fluorescent film 11.

The liquid sealant has heat conductivity, low volatility, and high burning point.

The liquid sealant is any one of heat conduction oil, silicone oil, ultrapure water, distilled water, and deionized water.

In assembly, the PCB 30 is retained in the bottom of the grid casing 20, the lid 40 covers the bottom of the grid casing 20 and fixes the PCB 30, and the transparent sheet 10 having the fluorescent film 11 is fixed on the fixing shoulder 23. Thereafter, the liquid sealant is fed into the grid casing 20 from two feeding orifices, and the two feeding orifices are closed after feeding the liquid sealant into the grid casing 20.

Thereby, the LED lamp of the present invention dissipates heat quickly by using the liquid sealant and is simplified.

The LED lamp of the present invention is packaged by the liquid sealant, and the multiple LED chips are fixed on the PCB, such that after the liquid sealant is fed into the grid casing, the heat of the multiple LED chips is dissipated through the liquid sealant quickly.

Preferably, said each LED chip emits the lights in said each refraction room of the grille portion so as to enhance luminous efficiency by using said each refraction room. Furthermore, said each refraction room of the grille portion accommodates the liquid sealant so that when the liquid sealant is fed into the grille portion of the grid casing, the liquid sealant contacts with said each LED chip and the fluorescent film, hence the lights quickly transmits to exterior environment via the liquid sealant and the fluorescent film.

While the preferred embodiments of the invention have been set forth for the purpose of disclosure, modifications of the disclosed embodiments of the invention as well as other embodiments thereof may occur to those skilled in the art. Accordingly, the appended claims are intended to cover all embodiments which do not depart from the spirit and scope of the invention.

## Claims

1. An LED lamp packaged by liquid sealant comprising: a transparent sheet (10), a grid casing (20), a printed circuit board (PCB) (30), and a lid (40);
the transparent sheet (10) covering on a top of the grid casing (20), the PCB (30) being defined between the grid casing (20) and the lid (40), and the lid (40) covering a bottom of the grid casing (20) and fixing the PCB (30);
**characterized in that**
the grid casing (20) includes at least one feeding orifice formed on the top thereof and communicating with an accommodation chamber (24) defined on the bottom of the grid casing (20), and liquid sealant is fed into the grid casing (20) from the at least one feeding orifice, and after feeding the liquid sealant into the grid casing (20), the least one feeding orifice is closed.

2. The LED lamp as claimed in claim 1, **characterized in that** the grid casing (20) includes a surrounding portion (21) and a grille portion (22) surrounded by the surrounding portion (21), wherein the grille portion (22) has multiple refraction rooms, and each of the multiple refraction room is in an inverted cone shape.

3. The LED lamp as claimed in claim 2, **characterized in that** the grid casing (20) further includes a fixing shoulder (23) surrounding the top of the grille portion (22), wherein a size of the fixing shoulder (23) is equal to the transparent sheet (10) so that the fixing shoulder (23) fixes the transparent sheet (10).

4. The LED lamp as claimed in claim 2, **characterized in that** the PCB (30) is accommodated under the grille portion (22) and includes multiple LED chips (31) fixed thereon, wherein each of the multiple LED chips (31) corresponds to said each refraction room of the grille portion (22).

5. The LED lamp as claimed in claim 4, **characterized in that** the PCB (30) is a ceramic PCB or an aluminum PCB.

6. The LED lamp as claimed in claim 1, **characterized in that** the grid casing (20) further includes the accommodation chamber (24) defined on the bottom thereof, and the lid (40) retains in the accommodation chamber (24) of the grid casing (20) so as to fix the PCB (30).

7. The LED lamp as claimed in claim 6, **characterized in that** the accommodation chamber (24) is rectangular and communicating with the surrounding portion (21) of the grid casing (20), such that the lid (40) retains in the accommodation chamber (24) of the grid casing (20).

8. The LED lamp as claimed in claim 1, **characterized in that** the transparent sheet (10) includes a fluorescent film (11) facing to the grid casing (20).

9. The LED lamp as claimed in claim 1, **characterized in that** the liquid sealant has heat conductivity, low volatility, and high burning point.

10. The LED lamp as claimed in claim 9, **characterized in that** the liquid sealant is any one of heat conduction oil, silicone oil, ultrapure water, distilled water, and deionized water.
